# EUROPEAN PATENT SPECIFICATION

(11) **EP 1 617 533 B1**
(45) Date of publication and mention of the grant of the patent: **22.12.2010**
(21) Application number: 04728254.6
(22) Date of filing: 19.04.2004
(51) Int. Cl.: H01S 5/16

(54) **METHOD OF MANUFACTURING A SEMICONDUCTOR DEVICE**
VERFAHREN ZUR HERSTELLUNG EINES HALBLEITERBAUELEMENTS
PROCEDE DE FABRICATION D'UN DISPOSITIF SEMI-CONDUCTEUR

(30) Priority: 18.04.2003 JP 2003114841
(43) Date of publication of application: 18.01.2006
(73) Proprietor: The Furukawa Electric Co., Ltd., Chiyoda-ku Tokyo 100-8322 (JP)
(72) Inventor: YAMADA, Yumi,, Ibaraki 310-055 (JP); IZUMI, Akira, Kitakyusyu-shi, Fukuoka 804-0015 (JP)
(74) Representative: Muschke, Markus Artur Heinz
(86) International application number: PCT/JP2004/005542
(87) International publication number: WO 2004/093274

(56) References cited:
- EP-A- 1 251 608
- WO-A1-02/17450
- JP-A- 5 110 185
- JP-A- 7 154 026
- JP-A- 2001 185 809
- JP-A- 2003 086 894
- US-A- 5 403 774
- US-A- 5 843 802
- US-A1- 2002 041 031
- PATENT ABSTRACTS OF JAPAN vol. 2000, no. 24, 11 May 2001 (2001-05-11) -& JP 2001 185809 A (MITSUBISHI CHEMICALS CORP), 6 July 2001 (2001-07-06)
- KUDO A ET AL: "STUDY ON IMPROVEMENT ON UNIFORMITY OF CAT-CVD SINX THIN FILMS" DENSHI JOHO TSUSHIN GAKKAI GIJUTSU KUNKYU HOKOKU - IEICE TECHNICAL REPORT, DENSHI JOHO TSUSHIN GAKKAI, TOKYO, JP, vol. 99, no. 3, April 1999 (1999-04), pages 59-66, XP001055083 ISSN: 0913-5685
- KUDO ET AL.: 'Cat-CVD SiNx-maku no mennai kin'itsusei kojo ni kansuru keinto' THE INSTITUTE OF ELECTRONICS, INFORMATION AND COMMUNICATION ENGINEERS SHINGAKU GIHO ED99-10 April 1999, pages 59 - 66, XP001055083
- SAITO ET AL.: 'Cat-CVD SiNx yudendotaimaku no handotai laser tanmen coating eno oyo' DAI 49 KAI OYO BUTURI GAKKAI KANKEI RENGO KOENKAI KOEN YOKOSHU March 2000, page 70, XP002984752

## Description

### TECHNICAL FIELD

The present invention relates to a method of fabricating a semiconductor device that includes a portion to be partially disordered, such as a window structure in a semiconductor laser device, by using a thin film deposition method such as the catalytic chemical vapor deposition (CVD) method or the hot wire cell method, which are capable of depositing a thin film of high compactness at low temperatures.

### BACKGROUND ART

JP2001185809A describes a method of manufacturing a high performance semiconductor aperture structure laser. A protective film is formed by plasma chemical vapor deposition on the entire top surface of a workpiece. The workpiece has the shape of a cuboid with a groove on top and comprises several semiconductor layers. On top of the workpiece, near each of two end-faces the protective film is etched away. Thereby, on top of the workpiece, stripe-like openings are formed by photolithography for uncovering a portion of a top n-type cap layer, and for uncovering portions of sidewalls of an n-type current block layer. On the stripe-like openings, an impurity diffused layer and a top cap layer are subsequently formed. By annealing at 700° C for one hour an impurity diffusion is performed within the same CVD system. As a result the workpiece includes a disordered portion and a non-disordered portion.

EP1251608A1 describes a method for manufacturing a semiconductor laser bar. A resonator plane of the semiconductor laser is formed by cleaving in the air. Thereby, a surface layer made of a natural oxide film is formed on the cleavage plane. The natural oxid film is exposed in a catalytic CVD apparatus to a gas containing N-atoms, which are changed into radical. The oxide layer is removed by etching using the radical produced by decomposition of a gas containing N-atoms. The same gas forms a protection film, which is a nitride film. The formation of GaN on a surface layer has an effect of terminating and decreasing defects generated on the cleavage surface. While etching, a portion of the semiconductor laser bar - except for a cleaving plane - is coated with metal electrode. Therefore, the portion of the semiconductor bar - except for the cleavage plane - is not exposed to the radical produced by decomposition of a gas containing N-atoms.

US2002/0041031A1 describes a method for fabricating a multilayer wiring structure. An interlayer insulating layer of a silicon nitride film is formed from common gas under low temperature through a catalytic CVD method. The interlayer insulating layer is arranged between wiring layers inside a miniaturized semiconductor. The top of the interlayer insulating film is formed by CVD (chemical vapor deposition) using CMP (chemical mechanical polishing) method. In addition, a silicon nitride film is evenly formed by CVD on a planarized surface over a multi-layer wiring structure.

US 5,843,802 describes a method of fabricating a semiconductor laser device to selectively disable a critical region of a laser array without detrimentally affecting closely adjacent critical regions. The selective disabling of the first critical region is used for building a stacked laser array structure for generating multiple semiconductor laser spots at different wavelengths. Because carriers preferentially populate the lowest energy active region in a stacked active region layer structure, the longer wavelength active region must be removed from the stack of the dual-wavelength laser array in areas where a shorter emission wavelength is desired. The concept involves intermixing a longer wavelength quantum well with surrounding layers, while preserving the shorter wavelength quantum well. An unwanted quantum well of a laser array is selectively eliminated through vacancy-enhanced intermixing forming an intermixed region of an AlGaAs layer under the SiO₂. During an annealing, a first portion of the surface of a semiconductor alloy is capped with a SiO₂ cap for absorbing out-diffusing Ga and for acting as a source of Ga vacancies. The SiO₂ is used to promote Si diffusion and intermixing on a column III sublattice. A second portion of the surface of the semiconductor alloy is capped with a suitable barrier material, as Si₃N₄, to prevent a loss of column III or column V species from the surface during annealing. A Si₃N₄ cap is placed on a portion of the surface of the semiconductor device, wherein the portion corresponds to a region of the AlGaAs layer which is not to be disordered. This region of the AlGaAs layer remains essentially unchanged and thus keeps an intact active region. After the annealing, the semiconductor device comprises a disordered portion and a non-disordered portion.

US 5,403,774 discloses a method of altering a refractive index, as for an optical waveguide, as in a buried heterostructure laser, by inducing disordering in a region of a semiconductor body, comprising exposing a surface portion of the semiconductor body to plasma etching, coating at least a part of the surface portion with an oxide layer and heat treating the semiconductor body at 850°C for a period of up to several hours.

Conventionally, light-emitting facets of semiconductor laser devices are susceptible to a catastrophic optical damage (COD). The COD is a phenomenon in which a feedback cycle of: increase in temperature of a facet → shrinkage of band gap → light absorption → recombination current flow → increase in temperature of the facet, is created on an emitting-side facet of an active layer, which becomes a positive feedback to cause melting and instantaneous deterioration of the facet.

A window structure is usually formed at the emitting-side facet of the active layer in order to prevent such COD. The window structure broadens an energy band gap in the emitting-side facet, whereby the facet has less absorption of laser light. As a result, the COD is suppressed and a semiconductor laser device with long lifetime is realized.

The window structure has been conventionally formed by an independent semiconductor process. For example, a portion where the window structure is to be formed is removed by etching or the like, and thereafter, materials with property corresponding to the window structure are embedded into the portion. The forming of the window structure is also achieved by disordering a portion to be the window structure. When the active layer has a superlattice structure, the process of disordering is performed by introducing impurities by an ion implantation or a thermal treatment into the superlattice structure of a portion where the window structure is to be formed, followed by a thermal treatment with a dielectric film to generate lattice vacancies so that constitutional elements of the respective layers that are spatially separated by hetero interfaces are mixed. The disordered portion exhibits properties different from those before implementing the process of disordering. For example, the portion has different band-gap energy and different refractive index (see Japanese Patent Application Laid-Open No. 2000-208870).

However, when the window structure is formed by the process of disordering, a thermal treatment must be performed for diffusion of impurities or vacancies. Since the thermal treatment is performed for the entire semiconductor laser device, the thermal treatment adversely affects portions that do not need to be disordered, causing deterioration of performance of the semiconductor laser device.

When the active layer is made of AlGaAs based materials and a part of the active layer is disordered by depositing a silicon dioxide (SiO₂) film, which serves as an enhance film for disordering, on an upper surface of the window structure to be disordered, arsenic (As) atoms are desorbed from a device surface corresponding to the active layer that is not to be disordered and the surface is roughened. When an electrode is formed on a contact layer, favorable contact between the electrode and the contact layer is not assured and a laser oscillation performance is deteriorated.

Particularly, desorbed As atoms from GaAs contact layer of the device surface leaves pits, which are a cause of dislocation defects that grow through non-radiative recombination to reach the active layer, which also deteriorates the laser oscillation performance.

Conventionally, deposition of silicon nitride (SiNₓ) by plasma-enhanced chemical vapor deposition (PECVD) method on the entire upper surface of a semiconductor laser device, so as to function as a heat-resistant protective film, is considered as a method of preventing desorption of As. However, the PECVD method is likely to cause plasma damage on the surface of the semiconductor device, which generates a dislocation defect. Furthermore, the deposited film is coarse and does not sufficiently function as the heat-resistant protective film.

In view of the above problems, an object of the present invention is to provide a method of fabricating a semiconductor device such as a semiconductor laser device, in which only a portion to be partially disordered, such as a portion to be a window structure, is disordered with no adverse effect on the other portions not to be disordered, and thereby to provide a method of fabricating a semiconductor device of high output power, long lifetime, and high reliability.

### DISCLOSURE OF INVENTION

To solve the above problems and to achieve the object, a method of fabricating a semiconductor device that includes a disordered portion, according to one aspect of the present invention, includes the step of forming a protective film on a surface of the semiconductor device corresponding to at least a portion that is not to be disordered, by arranging a heat source on a path through which a precursor of the protective film to be formed passes, to cause a decomposition reaction of the precursor in the presence of the heat source, and exposing the surface of the semiconductor device to the atmosphere after the decomposition reaction; and the step of disordering the portion to be disordered using a thermal treatment.

Furthermore, according to the present invention, the semiconductor device is a semiconductor laser device that includes a window structure as the disordered portion, and an active layer of quantum well structure as the portion not to be disordered.

Moreover, the present invention includes the step of pretreatment in which a disordering-enhancing film is formed adjacent to a portion to be disordered, and the step of forming a protective film comprises the step of forming a protective film adjacent to at least a portion that is not to be disordered.

Furthermore, according to the present invention, the disordering-enhancing film is made of silicon dioxide (SiO2).

Moreover, according to the present invention, the step of forming a protective film includes forming the protective film using a catalytic chemical-vapor-deposition method.

Furthermore, according to the present invention, the precursor is a compound containing nitrogen and silicon.

Moreover, according to the present invention, the precursor is a mixture of a nitrogen compound and a silicon compound.

### BRIEF DESCRIPTION OF DRAWINGS

Figs. 1A to 1F are schematics for illustrating a method of fabricating a semiconductor device according to an embodiment of the present invention;
Figs. 2A and 2B are schematics for illustrating the method of fabricating a semiconductor device according to the embodiment;
Fig. 3 is a schematic of a catalytic CVD equipment, used in the method according to the embodiment;
Fig. 4 is a schematic for illustrating phenomena to occur in a portion to be disordered and a potion not to be disordered, in the method according to the embodiment;
Fig. 5 is a schematic for illustrating pits and cracks generated by the pits in a semiconductor device;
Fig. 6 is a graph of injection current versus light output of a semiconductor laser device with and without a window structure according to the embodiment; and
Fig. 7 is a schematic for illustrating an example of depositing a protective film that covers at least the potion not to be disordered, in the method according to the embodiment.

### BEST MODE FOR CARRYING OUT THE INVENTION

Exemplary embodiments of the present invention will be explained in detail below with reference to the accompanying drawings. The invention is not limited to the embodiments.

### [Embodiments]

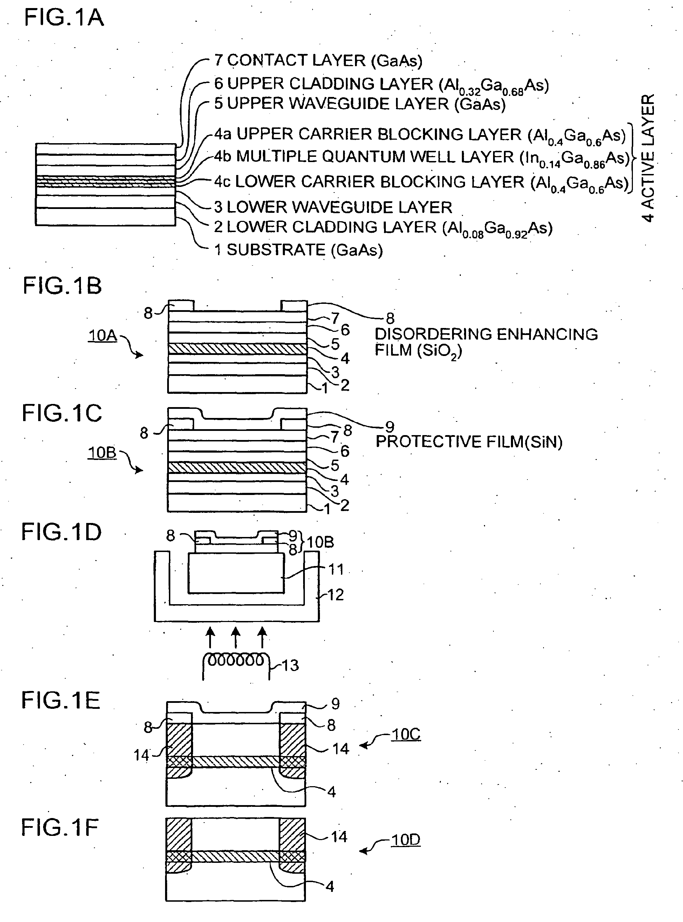

Figs. 1A to 2B are schematics for illustrating a method of fabricating a semiconductor device according to an embodiment of the present invention. The semiconductor device is a semiconductor laser device having multiple quantum well (MQW) structure that outputs laser light within a wavelength band of 0.98 micrometer. The semiconductor laser device includes a lower cladding layer 2, a lower waveguide layer 3, an active layer 4, an upper waveguide layer 5, an upper cladding layer 6, and a contact layer 7 grown in this order on a substrate 1. The active layer 4 is formed by successively growing a lower carrier blocking layer 4c, a multiple quantum well layer 4b, and an upper carrier blocking layer 4a. Since the layers preferably have a superlattice structure, they are grown by metal organic chemical vapor deposition (MOCVD) or molecular beam epitaxy (MBE).

First, a method of fabricating the semiconductor laser device will be described according to the sequence of fabrication. As shown in Fig. 1A, a Al_{0.08}Ga_{0.92}As lower cladding layer 2 with a thickness of 2.4 micrometers is grown on a GaAs substrate 1. A GaAs lower waveguide layer 3 with a thickness of 0.48 micrometer is then grown on the lower cladding layer 2. An active layer 4 is then formed on the lower waveguide layer 3.

The active layer 4 is formed by growing a Al_{0.4}Ga_{0.6}As lower carrier blocking layer 4a with a thickness of 0.035 micrometer, the multiple quantum well layer 4b with two stacked In_{0.19}Ga_{0.86}As layers each with a thickness of 0.01 micrometer on the lower carrier blocking layer 4a, and a Al_{0.4}Ga_{0.6}As upper carrier blocking layer 4c with a thickness of 0.035 micrometer on the multiple quantum well layer 4b.

The GaAs upper waveguide layer 5 with a thickness of 0.45 micrometer is formed on the active layer 4, the Al_{0.32}Ga_{0.68} As upper cladding layer 6 with a thickness of 0.8 micrometer is formed on the upper waveguide layer 5, and a GaAs contact layer 7 with a film thickness of 0.3 micrometer is formed on the upper cladding layer 6.

After the contact layer 7 with a superlattice structure is formed, a disordering-enhancing film 8 made of SiO₂ is deposited on the entire upper portion of the contact layer 7 to a film thickness of 20 nanometers by using electron beam evaporation method. Thereafter, the disordering-enhancing film 8 is removed by using a photolithographic technique, except for portions corresponding to a window structure 14. As a result, as shown in Fig. 1B, the device substrate 10A with the disordering-enhancing film 8 deposited only on portions corresponding to the window structure 14 is obtained. The disordering-enhancing film 8 corresponds to the active layer 4 formed in a stripe shape, and is formed in a stripe with a width of 20 micrometers so as to cover the active layer 4.

As shown in Fig. 1C, a protective film 9 made of SiNₓ is deposited on the entire upper portion of the substrate including the disordering-enhancing film 8 to a thickness of 50 nanometers by using a catalytic CVD method. As a result, the device substrate 10B with the protective film 9 deposited thereon is obtained. Thereafter, the rapid thermal anneal (RTA) is performed on the device substrate 10B to cause disordering of the portion beneath the disordering-enhancing film 8, thereby to form a window structure 14 in that portion.

As shown in Fig. 1D, the RTA is performed by placing the device substrate 10B on a mount 11 made of silicon carbide (SiC), arranging the mount 11 within a quartz tray 12, and heating a lamp heater 13 below the quartz tray 12 in a nitrogen (N₂) gas atmosphere to 930°C for 30 seconds.

During the process of RTA, gallium (Ga) atoms are absorbed from the respective layers under the disordering-enhancing film 8 into the disordering-enhancing film 8, leaving vacancies on the surface. The vacancies are diffused, particularly into the active layer 4 to disorder the active layer. By the process, as shown in Fig. 1E, a device substrate 10C with the window structure 14 is obtained.

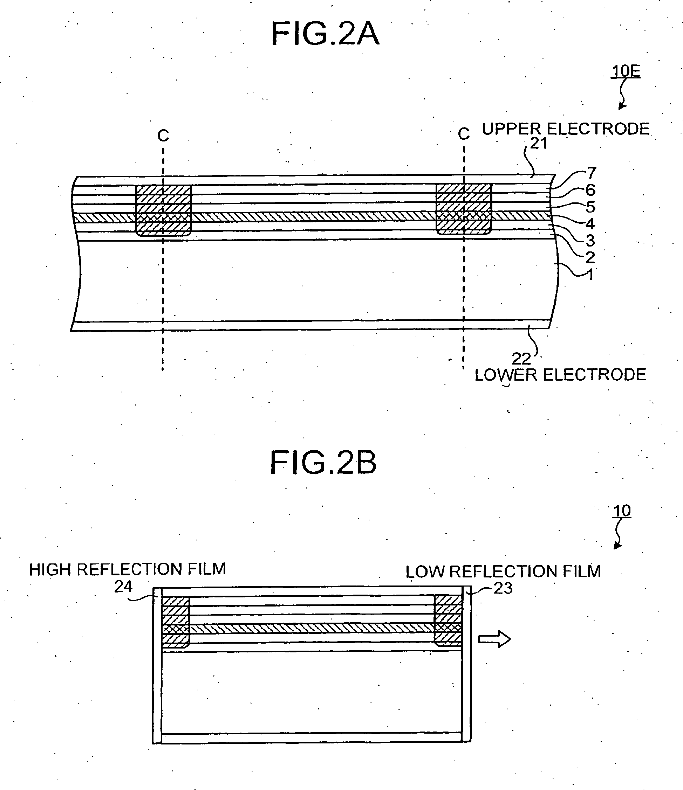

After the window structure 14 is formed, as shown in Fig. 1F, the protective film 9 and the disordering-enhancing film 8 are removed to obtain a device substrate 10D. Thereafter, as shown in Fig. 2A, an upper electrode 21 and a lower electrode 22 are then formed on the device substrate 10D to obtain a device substrate 10E with the electrode structure. The respective steps explained above are performed on the substrate 1.

The device substrate 10E with the lower electrode 22 is cleaved along a broken line C shown in Fig. 2A, so that a laser bar containing a plurality of semiconductor laser devices is separated. As shown in Fig. 2B, on the cleavage surfaces of the separated laser bar, a low reflection film 23 is coated for its emission side and a high reflection film 24 is coated for its reflection side. The laser bar is cut, in parallel with the paper surface of the drawing, into the respective semiconductor laser devices, to complete the fabrication of semiconductor laser devices 10.

A method of depositing the protective film 9 is explained next. The protective film 9 made of SiNₓ is deposited using a catalytic CVD method. According to the catalytic CVD method, source gases for forming the protective film 9 are catalytically decomposed by a heated catalyzer and chemical reactions occur on a film to be formed. As a result, the protective film 9 is formed.

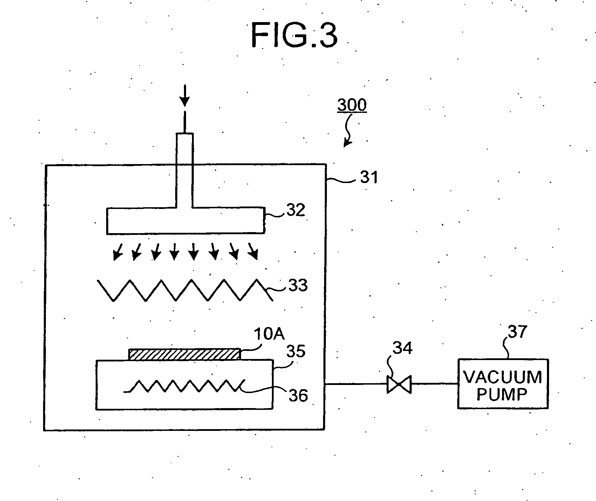

Fig. 3 is a schematic of a catalytic CVD equipment 300. As shown in Fig. 3, the catalytic CVD device 300 includes a chamber 31 in which the protective film 9 is deposited, a shower head 32 to introduce source gases for the protective film 9 into the chamber 31, a filament (tungsten wire) 33 serving as a heated catalyzer, a substrate holder 35 on which the substrate 1 is placed, a substrate heater 36 to heat the device substrate 10A, a vacuum pump 37 to evacuate the chamber 31, and a pressure adjustment valve 34 to adjust the pressure within the chamber 31. The tungsten wire 33 is placed between the shower head 32 and the substrate holder 35. After the pressure of the chamber 31 is reduced, source gases are introduced from the shower head 32 into the chamber 31, and contact the tungsten wire 33 to be decomposed thereat. The decomposed source gases flow on the device substrate 10A placed on the substrate holder 35.

Next, a process of depositing the protective film 9 is explained below. The device substrate 10A is placed on the substrate holder 35. The vacuum pump 37 is then operated and the pressure adjustment valve 34 is opened so that the pressure within the chamber 31 is reduced to a predetermined pressure. When the pressure within the chamber 31 is reduced to the predetermined pressure, the substrate heater 36 is energized to maintain the temperature of the substrate at about 250°C.

Ammonia (NH₃) gas is introduced via the shower head 32 into the chamber 31 at a flow rate of 200 sccm. The tungsten wire 33 is energized so as to maintain its temperature at 1680°C. Silane gas (SiH₄) is introduced via the shower head 32 into the chamber 31 at a flow rate.of 2 sccm and the pressure adjustment valve 34 is adjusted so as to maintain the pressure within the chamber 31 at 4.0 Pascals. 360 seconds thereafter, introduction of SiH₄ is stopped, energizing of the tungsten wire 33 is stopped, introduction of NH₃ is stopped, the pressure adjustment valve 34 is closed. Dry nitrogen gas (N₂) is introduced to return the pressure of the chamber 31 to atmospheric pressure. Thus, the device substrate 10B with the 50 nanometer-thick SiNₓ protective film 9 formed thereon is obtained.

During the above process, SiH₄ molecules and NH₃ molecules introduced into the chamber 31 contact the heated tungsten wire 33 to be decomposed into active SiH_{Y} and NH_{Z}, which reach onto the device substrate 10A. Since SiH_{Y} and NH_{z} are activated, chemical reactions proceed on the device substrate 10A at a relatively low temperature of 250°C, and thereby, SiN_{X} is generated.

The protective film 9 has a smaller amount of oxygen and hydrogen mixed therein and therefore has a higher compactness than films deposited by a PECVD method. In addition, since the protective film.9 is deposited at a lower temperature as compared to films deposited by thermal CVD method, its internal stress arising from thermal non-equilibrium is small. Thus, the protective film 9 has chemically and physically stable characteristics

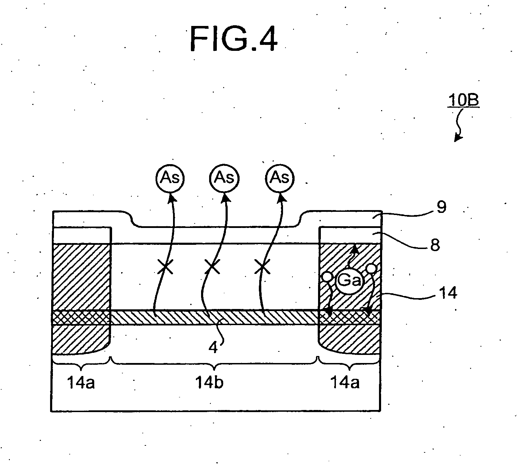

Effects of the protective film 9 are explained next. Fig. 4 is a cross section of the device substrate 10B. As shown in Fig. 4, the protective film 9 is deposited on an upper portion of an area 14b where the window structure 14 is not formed. When RTA is performed for the purpose of disordering, the above characteristics of the protective film 9 is helpful in preventing desorption of As atoms from a part of the active layer 4 corresponding to the area 14b. Therefore, during the process of RTA, a part of the active layer 4 corresponding to the area 14a is disordered while a part of the active layer 4 corresponding to the area 14b is not disordered. With the protective film 9, the process of disordering is selectively performed in a successful manner, with no damage on the multiple quantum well (MQW) structure of the active layer 4 and with no deterioration in performance of a laser light output.

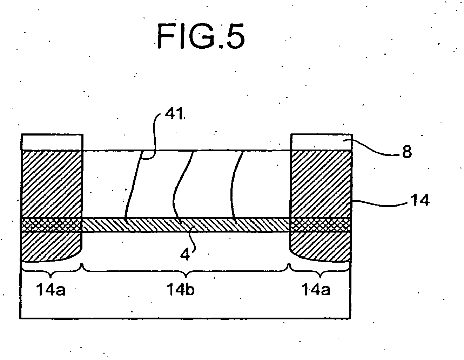

Moreover, as shown in Fig. 5, since desorption of As atoms in the area 14b is prevented, the surface of the upper contact layer 7 is smooth and free from pits 41 due to the desorption of As atoms. Consequently, the device is free from cracks generated due to the pits 41 and favorable contact between the contact layer 7 and the upper electrode 21 is assured.

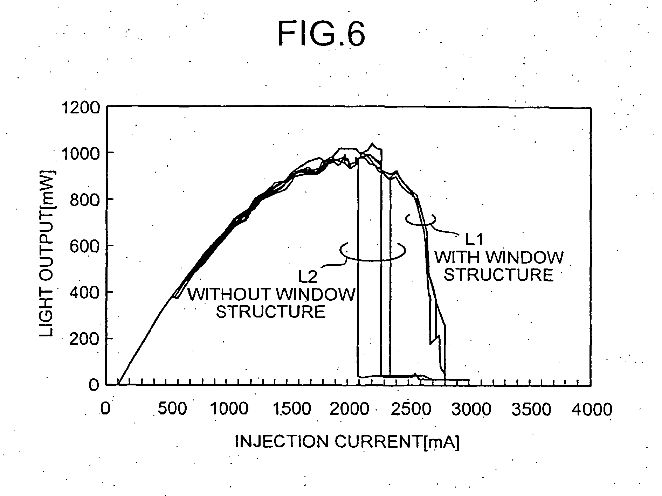

Fig. 6 is a graph showing the difference in light-to-injection current characteristics between the semiconductor laser device with the window structure 14 and the semiconductor laser device without the window structure 14. As shown in Fig. 6, in the semiconductor laser device without the window structure 14, an increase in injection current causes an increase in light output, which lead to an increase in the amount of heat generated. The increase in the amount of heat generated causes a thermal saturation of light output at the injection current of around 2000 to 2500 milliamperes, where COD occurs at the facet (see L2 in Fig. 6). On the other hand, in the semiconductor laser device with the window structure 14, although the light output decreases due to thermal saturation, COD does not occur (see L1 in Fig. 6). Since the laser light output facet is strengthened by the window structure 14, the semiconductor laser device 10 can emit higher output power and enjoy longer lifetime. Particularly, the process of disordering to form the window structure in the fabricating method according to the embodiment does not affect the active layer 4, causing no deterioration in the light output performance of the semiconductor laser device 10.

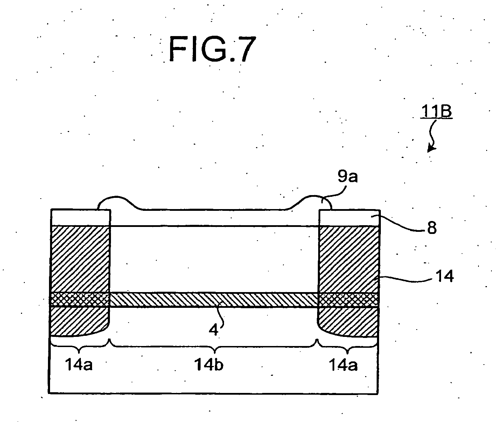

While the protective film 9 is deposited so as to cover the entire surface of the device substrate in this embodiment, a device substrate 11B with a protective film 9a deposited.thereon so as to cover at least the area 14b may be used, as shown in Fig. 7. Namely, the protective film 9 may be deposited so as to cover at least the portion corresponding to the area 14b that is not to be subjected to a process of disordering.

While in this embodiment an example is described in which the process of disordering is performed with the disordering-enhancing film 8 deposited, the present invention is not limited to such example but can be applied to performing the process of disordering by diffusing impurities such as Zn and Si by a thermal treatment.

While SiH₄ and NH₃ are used as materials (precursors) for depositing a SiNₓ film serving as the protective film 9 in this embodiment, the present invention is not limited to such materials. Precursors containing Si and N can be used or precursors prepared by combining Si with NH₃ can be used.

While a process of disordering to form a window structure of the semiconductor laser device 10 is described in this embodiment, the present invention is not limited to forming the window structure. The present invention can be generally applied to disordering of local areas.

While a heating temperature of the tungsten wire.33 is set to 1680°C in this embodiment, the heating temperature of the tungsten wire 33 may be higher than a temperature above which the tungsten wire 33 is not silicided and lower than a temperature below which a vapor pressure of the tungsten wire 33 does not affect deposition of the protective film 9. Therefore, the heating temperature of the tungsten wire 33 can be set to between 1600°C and 1900°C, for example.

A flow rate of NH₃ gas to SiH₄, a pressure within the chamber 31, and the like can be set optimally to realize high compactness of the protective film 9.

The semiconductor laser device 10 is not limited to one of a particular laser structure or of a particular composition, but may generally be a semiconductor laser device of any structure. While a composition of an active area used for the semiconductor laser device 10 can be selected from GaAs, AlGaAs, InGaAs, InAlGaAs, InGaAsP, and the like depending on oscillation wavelengths, other compositions can be used.

As described above, according to the present invention, a method of fabricating a semiconductor device such as a semiconductor laser device, in which only a portion to be partially disordered, such as a portion to be a window structure, is disordered with no adverse effect on the other portions not to be disordered, and thereby to provide a method of fabricating a semiconductor device of high output power, long lifetime, and high reliability.

### INDUSTRIAL APPLICABILITY

As described above, the present invention is suitable for a semiconductor device that includes a portion to be partially disordered such as a window structure in a semiconductor laser device, and is suitable for fabricating such semiconductor devices.

## Claims

1. A method of fabricating a semiconductor device that includes a disordered portion and a non-disordered portion, the method comprising:
forming a protective film (9) on a surface of the semiconductor device corresponding to at least one portion (14b) that is not to be disordered, by arranging a heat source (33) on a path through which a precursor of the protective film (9) to be formed passes to cause a decomposition reaction of the precursor in the presence of the heat source (33), and by exposing the surface of the semiconductor device to the atmosphere after the decomposition reaction; and
disordering the portion (14a) to be disordered in the semiconductor device through vacancy diffusion using a rapid thermal anneal process, wherein
the semiconductor device includes
a window structure (14) as the disordered portion (14a); and
an active layer of a quantum well structure as the non-disordered portion (14b).

2. The method according to claim 1, wherein
the forming of a protective film (9) includes depositing the protective film.(9) using a catalytic chemical-vapor-deposition.

3. The method according to one of claims 1or 2, wherein
the precursor includes a compound containing nitrogen and silicon.

4. The method according to one of claims 1 to 3, wherein
the precursor includes a mixture of a nitrogen compound and a silicon compound.

5. A method of fabricating a semiconductor device according to claim 1 that includes a disordered portion and a non-disordered portion, the method further comprising:
forming a disordering-enhancing film (8) on a first surface of the semiconductor device covering a first portion which corresponds to said portion (14a) to be disordered;
wherein the protective film (9) is on a second surface of the semiconductor device, which second surface corresponds to said at least one portion (14b) that is not to be disordered.

6. The method according to claim 5, wherein
the disordering-enhancing film (8) includes a dielectric film made of silicon dioxide.

7. The method according to one of claims 5 or 6, wherein
the forming a protective film (9) includes depositing the protective film (9) using a catalytic chemical-vapor-deposition.

8. The method according to one of claims 5 to 7, wherein
the precursor includes a compound containing nitrogen and silicon.

9. The method according to one of claims 5 to 8, wherein
the precursor includes a mixture of a nitrogen compound and a silicon compound.

## Patentansprüche

1. Verfahren zum Herstellen einer Halbleitervorrichtung, die einen fehlgeordneten Abschnitt und einen nicht fehlgeordneten Abschnitt aufweist, wobei das Verfahren umfasst:
Bilden einer dünnen Schutzschicht (9) auf einer Oberfläche der Halbleitervorrichtung, die wenigstens einem Abschnitt (14b), der nicht fehlgeordnet werden soll, entspricht, durch Anordnen einer Wärmequelle (33) auf einem Weg, auf dem sich ein Vorläufer der zu bildenden dünnen Schutzschicht (9) bewegt, um eine Zerlegungsreaktion des Vorläufers in Gegenwart der Wärmequelle (33) hervorzurufen, und durch Beaufschlagen der Oberfläche der Halbleitervorrichtung mit der Atmosphäre nach der Zerlegungsreaktion; und
Fehlordnen des Abschnitts (14a), der in der Halbleitervorrichtung fehlgeordnet werden soll, durch Gitterfehlstellendiffusion unter Verwendung eines schnellen thermischen Glühprozesses, wobei
die Halbleitervorrichtung umfasst:
eine Fensterstruktur (14) als den fehlgeordneten Abschnitt (14a); und
eine aktive Schicht einer Quantentopfstruktur als den nicht fehlgeordneten Abschnitt (14b).

2. Verfahren nach Anspruch 1, wobei
das Bilden einer dünnen Schutzschicht (9) das Ablagern der dünnen Schutzschicht (9) unter Verwendung einer katalytischen chemischen Abscheidung aus der Dampfphase umfasst.

3. Verfahren nach einem der Ansprüche 1 oder 2, wobei
der Vorläufer eine Verbindung enthält, die Stickstoff und Silicium enthält.

4. Verfahren nach einem der Ansprüche 1 bis 3, wobei
der Vorläufer ein Gemisch aus einer Stickstoffverbindung und einer Siliciumverbindung enthält.

5. Verfahren zum Herstellen einer Halbleitervorrichtung nach Anspruch 1, die einen fehlgeordneten Abschnitt und einen nicht fehlgeordneten Abschnitt aufweist, wobei das Verfahren ferner umfasst:
Bilden einer dünnen Fehlordnungssteigerungsschicht (8) auf einer ersten Oberfläche der Halbleitervorrichtung, die einen ersten Abschnitt abdeckt, der dem Abschnitt (14a), der fehlgeordnet werden soll, entspricht;
wobei sich die dünne Schutzschicht (9) auf einer zweiten Oberfläche der Halbleitervorrichtung befindet, wobei die zweite Oberfläche dem wenigstens einen Abschnitt (14b) entspricht, der nicht fehlgeordnet werden soll.

6. Verfahren nach Anspruch 5, wobei
die dünne Fehlordnungssteigerungsschicht (8) eine dünne dielektrische Schicht, die aus Siliciumdioxid hergestellt ist, enthält.

7. Verfahren nach einem der Ansprüche 5 oder 6, wobei
das Bilden einer dünnen Schutzschicht (9) das Ablagern der dünnen Schutzschicht (9) unter Verwendung einer katalytischen Abscheidung aus der Dampfphase umfasst.

8. Verfahren nach einem der Ansprüche 5 bis 7, wobei
der Vorläufer eine Verbindung enthält, die Stickstoff und Silicium enthält.

9. Verfahren nach einem der Ansprüche 5 bis 8, wobei
der Vorläufer ein Gemisch aus einer Stickstoffverbindung und einer Siliciumverbindung enthält.

## Revendications

1. Procédé de fabrication d'un dispositif semi-conducteur qui comprend une partie désorganisée et une partie non désorganisée, le procédé comprenant :
la formation d'un film protecteur (9) sur une surface du dispositif semi-conducteur correspondant à au moins une partie (14b) qui ne doit pas être désorganisée, en agençant une source de chaleur (33) sur un trajet à travers lequel un précurseur du film protecteur (9) à former passe pour causer une réaction de décomposition du précurseur en présence de la source de chaleur (33), et en exposant la surface du dispositif semi-conducteur à l'atmosphère après la réaction de décomposition ; et
la désorganisation de la partie (14a) à désorganiser dans le dispositif semi-conducteur par diffusion par lacunes en utilisant une procédure de recuit thermique rapide, où
le dispositif semi-conducteur comprend
une structure de fenêtre (14) en tant que partie désorganisée (14a) ; et
une couche active d'une structure de puits quantique en tant que partie non désorganisée (14b).

2. Procédé selon la revendication 1, **caractérisé en ce que**
la formation d'un film protecteur (9) comprend le dépôt du film protecteur (9) en utilisant un dépôt chimique en phase vapeur catalytique.

3. Procédé selon une des revendications 1 ou 2, **caractérisé en ce que**
le précurseur comprend un composé contenant de l'azote et du silicium.

4. Procédé selon une des revendications 1 à 3, **caractérisé en ce que**
le précurseur comprend un mélange d'un composé azoté et un composé de silicium.

5. Procédé de fabrication d'un dispositif à semi-conducteur selon la revendication 1 qui comprend une partie désorganisée et une partie non désorganisée, le procédé comprenant en outre :
la formation d'un film d'activation de désorganisation (8) sur une première surface du dispositif semi-conducteur recouvrant une première partie qui correspond à ladite partie (14a) à désorganiser ;
le film protecteur (9) étant sur une deuxième surface du dispositif semi-conducteur, ladite deuxième surface correspondant à ladite au moins une partie (14b) qui ne doit pas être désorganisée.

6. Procédé selon la revendication 5, **caractérisé en ce que**
le film d'activation de désorganisation (8) comprend un film diélectrique constitué de dioxyde de silicium.

7. Procédé selon une des revendications 5 ou 6, **caractérisé en ce que**
la formation d'un film protecteur (9) comprend le dépôt du film protecteur (9) en utilisant un dépôt chimique en phase vapeur catalytique.

8. Procédé selon une des revendications 5 à 7, **caractérisé en ce que**
le précurseur comprend un composé contenant de l'azote et du silicium.

9. Procédé selon une des revendications 5 à 8, **caractérisé en ce que**
le précurseur comprend un mélange d'un composé azoté et d'un composé de silicium.
